Europäisches Patentamt

European Patent Office

Office européen des brevets

(19)

(11) Numéro de publication: **0 199 386**
**B1**

(12) **FASCICULE DE BREVET EUROPEEN**

(45) Date de publication du fascicule du brevet:
**18.07.90**

(51) Int. Cl.⁵: **H01L 21/60, H01L 23/48**

(21) Numéro de dépôt: **86200451.2**

(22) Date de dépôt: **20.03.86**

(54) Procédé de réalisation d'électrodes conductrices d'un élément de circuit et dispositif semi-conducteur ainsi obtenu.

(30) Priorité: **26.03.85 FR 8504472**

(43) Date de publication de la demande:
**29.10.86 Bulletin 86/44**

(45) Mention de la délivrance du brevet:
**18.07.90 Bulletin 90/29**

(84) Etats contractants désignés:
**DE FR GB IT NL**

(56) Documents cités:
**EP-A- 0 085 777**
**FR-A- 2 372 511**
**US-A- 4 214 256**
**US-A- 4 381 215**

**PATENTS ABSTRACTS OF JAPAN, vol. 5, no. 205, (E-88)**
**[877], 25 décembre 1981; & JP - A - 56 124 232 (NIPPON**
**DENKI K.K.) 29-09-1981**

(73) Titulaire: **PHILIPS COMPOSANTS, 117, quai du Président**
**Roosevelt, F-92130 Issy les Moulineaux(FR)**
(84) Etats contractants désignés: **FR**

(73) Titulaire: **N.V. Philips' Gloeilampenfabrieken,**
**Groenewoudseweg 1, NL-5621 BA Eindhoven(NL)**
(84) Etats contractants désignés: **DE GB IT NL**

(72) Inventeur: **Barbu, Stefan, SOCIETE CIVILE**
**S.P.I.D. 209 Rue de l'Universite, F-75007 Paris(FR)**
Inventeur: **Chapron, Claude, SOCIETE CIVILE**
**S.P.I.D. 209 Rue de l'Universite, F-75007 Paris(FR)**

(74) Mandataire: **Jacquard, Philippe et al, SOCIETE CIVILE**
**S.P.I.D. 209, rue de l'Université, F-75007 Paris(FR)**

## Description

L'invention a trait à un procédé de réalisation d'électrodes conductrices d'un élément de circuit, procédé dans lequel on dépose selon un motif désiré des électrodes conductrices en mettant en œuvre un masque présentant des ouvertures positionnées par rapport à au moins deux fenêtres de contact adjacentes ménagées dans une couche isolante, réalisée sur la surface d'un corps semi-conducteur, lesdites fenêtres de contact adjacentes étant disposées au-dessus de deux régions de l'élément de circuit et séparées latéralement par au moins une région de couche isolante et présentant une couche de métal se combinant chimiquement avec le matériau de la surface du substrat de telle sorte que les surfaces du substrat mises à nu par les fenêtres soient recouvertes d'une couche de métal combiné, au moins une des deux électrodes conductrices pouvant ne recouvrir que partiellement la fenêtre de contact correspondante.

Un tel procédé, connu de l'antériorité US 4 381 215 a pour inconvénient que les régions étroites doivent avoir une largeur $E_0$ au moins égale à $B + 2A$, B désignant la distance minimale entre deux métallisations, et A la tolérance de positionnement du masque utilisé pour les métallisations par rapport aux fenêtres de contact.

La présente invention a pour objet un procédé permettant de s'affranchir de cette limitation.

Dans ce but, le procédé selon l'invention est caractérisé en ce qu'il comporte les étapes suivantes :

a) ouvrir dans la couche isolante lesdites fenêtres de contact de telle sorte que ladite région de couche isolante ait une largeur nominale E supérieure ou égale à C et inférieure à $B + 2A$, tout en étant suffisante pour que, compte tenu de la position relative des métallisations et de la région de couche isolante, et du fait que l'on accepte que, parmi deux électrodes conductrices adjacentes, au moins une d'entre elles puisse ne recouvrir que partiellement la fenêtre correspondante, il n'y ait pas de court-circuit entre deux régions adjacentes par pontage de ladite région de couche isolante dans les positions extrêmes des métallisations définies par la tolérance A avec

A = tolérance de positionnement des électrodes conductrices par rapport aux fenêtres.
B = écart minimal entre deux electrodes conductrices,
C = largeur minimale de la région de la couche isolante permise par les techniques de photogravure.

b) déposer ladite couche de métal
c) déposer à l'aide dudit masque lesdites électrodes conductrices selon le motif désiré.

Le procédé peut comporter entre l'étape a et l'étape b, une étape de réalisation d'au moins une des régions semi-conductrices du transistor.

Selon une première variante dans laquelle les métallisations sont au moins aussi larges que les fenêtres, la région de couche isolante a une largeur au moins égale à la distance entre les électrodes conductrices.

Dans ce cas, le procédé selon l'invention est tel que lesdites métallisations ont une largeur au moins égale à celle desdites fenêtres de contact correspondantes, et, dans les conditions nominales, ledit masque est disposé de manière telle qu'au moins un bord de chaque électrode conductrice susceptible de pouvoir ne recouvrir que partiellement la fenêtre correspondante coïncide avec le bord de la fenêtre correspondante jouxtant ladite région de la couche isolante et enfin la valeur nominale E de ladite région de couche isolante est au moins égale à la plus grande des deux valeurs :

A(3-p) ; B + (2-p)A.

avec p = nombre entier égal à 1 ou 2, selon qu'il soit toléré que, parmi deux métallisations adjacentes, une d'entre elles ou les deux puissent ne recouvrir que partiellement les fenêtres de contact correspondantes.

Selon un premier mode de réalisation de cette variante, le transistor est un transistor pour hautes fréquences ou à faible bruit et, pour conserver un contact émetteur de résistance minimale, un recouvrement seulement partiel n'est accepté que pour deux électrodes de base situées de part et d'autre d'une électrode d'émetteur (p = 1), la fenêtre de contact d'émetteur présentant donc deux régions de couche isolante qui le bordent latéralement, et sur lesquelles, en position nominale, la métallisation d'émetteur déborde de part et d'autre de la quantité A et en outre en position nominale, l'électrode de base remplit entièrement la fenêtre de contact de base, de telle sorte qu'on obtient un transistor de dimensions plus réduites que dans l'art antérieur.

Selon un deuxième mode de réalisation de cette variante, l'élément de circuit est un transistor, lequel comporte une première fenêtre de contact de base et une première fenêtre de contact d'émetteur, et la largeur E de la portion de couche isolante est égale à B.

Selon un troisième mode de réalisation de cette variante, on choisit p = 2, la couche isolante comporte une deuxième fenêtre de contact de base, et une deuxième fenêtre de contact d'émetteur, et, pour obtenir une résistance de base minimale, on impose d'une part que la largeur minimale de la portion des électrodes conductrices effectivement en contact avec le corps semi-conducteur soit dans chacune des fenêtres égale à une valeur donnée G, et d'autre part que la largeur des fenêtres de contact et des électrodes conductrices d'émetteur et de base soit égale à A + G. Cette disposition est surtout intéressante pour les électrodes d'émetteur. De ce fait, on peut prendre une valeur $G_1$ pour l'émetteur et $G_2$ pour la base.

Selon une deuxième variante visant à obtenir des dimensions latérales minimales, chaque électrode conductrice susceptible de ne pouvoir recouvrir que partiellement la fenêtre de contact correspondante a une largeur utile inférieure à celle de la fenêtre de contact correspondante.

Selon un mode de réalisation avantageux, la valeur nominale E de ladite région de couche isolante est au moins égale à 2A - (p - 1) B, avec p = nombre entier égal à 1 ou 2, selon qu'il soit toléré que, parmi deux électrodes conductrices adjacentes, une d'entre elles ou les deux puissent ne recouvrir que partiellement les fenêtres correspondantes. Si cette valeur E est inférieure à C, on choisit bien entendu la valeur C, (C a été défini ci-dessus).

Le transistor peut avantageusement être du type multicollecteurs notamment en logique intégrée à injection I$^2$L avec p = 2 et lesdites fenêtres de contact être des fenêtres de contact de collecteur, et/ou de base ou d'injecteur. Ladite valeur nominale E peut être inférieure à B.

L'invention sera mieux comprise à la lecture de la description qui va suivre donnée à titre d'exemple non limitatif, en liaison avec les figures qui représentent en coupe verticale :

- la figure 1, un transistor de l'art antérieur dont les électrodes conductrices sont représentées en leur position nominale ;
- les figures 2a à 2d, une illustration des étapes du procédé selon l'invention ;
- les figures 3a et 3b, les positions extrêmes susceptibles d'être occupées par les électrodes conductrices du transistor de la figure 2d dans les limites de la tolérance A de part et d'autre de la position nominale.
- les figures 4, 5a et 5b, un transistor hyperfréquences selon une variante de l'invention avec ses électrodes conductrices respectivement en position nominale, extrême vers la gauche, et extrême vers la droite.
- les figures 6, 7a et 7b (coupe partielle), un transistor multicollecteurs I$^2$L réalisé selon une deuxième variante de l'invention avec ses électrodes conductrices respectivement en position nominale, extrême vers la gauche et extrême vers la droite.
- les figures 8, 9a et 9b, un transistor hyperfréquences selon la deuxième variante de l'invention avec ses électrodes conductrices respectivement en position nominale, extrême vers la gauche et extrême vers la droite.

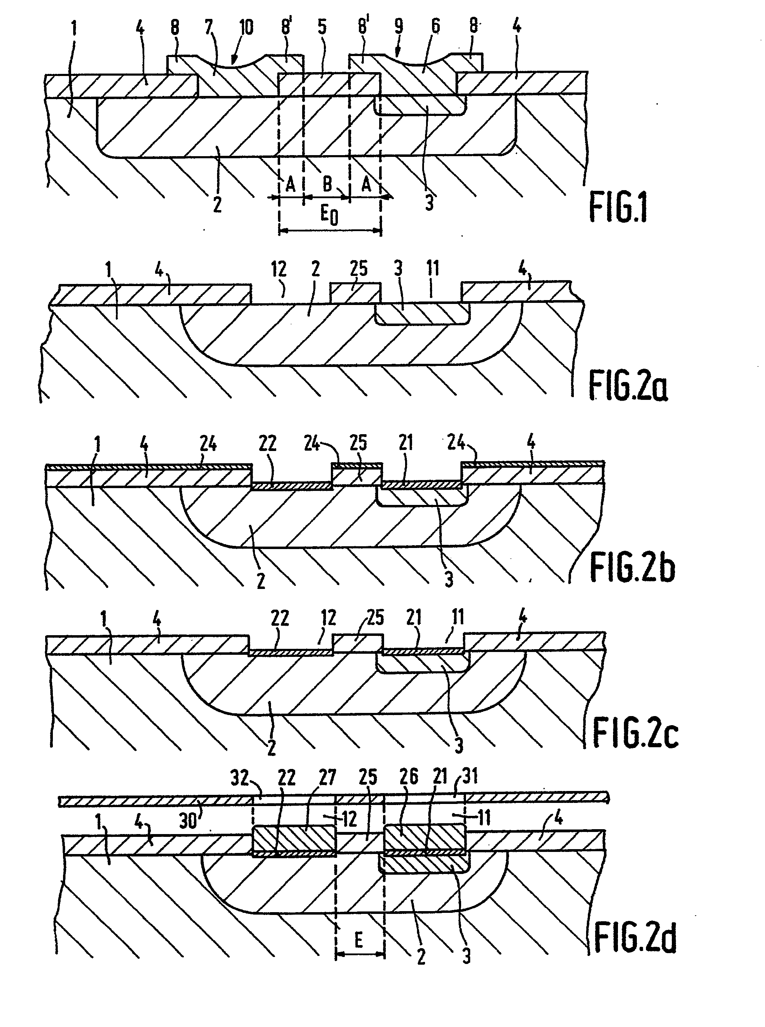

Selon la figure 1, un transistor fabriqué selon l'art antérieur sur un corps semi-conducteur 1 d'un premier type de conductivité et comportant une base 2 diffusée ou implantée du second type de conductivité opposé au premier et un émetteur 3 diffusé ou implanté dans une partie de la base 2, présente des électrodes conductrices, ici des métallisations d'émetteur 6 et de base 7 disposées respectivement dans des fenêtres 9 et 10 d'une couche isolante 4, la fenêtre 9 servant également pour la réalisation de l'émetteur. Les métallisations 6 et 7, dans leur position nominale, débordent latéralement en 8 d'une quantité A de part et d'autre sur la couche isolante 4. Cette quantité A est au moins égale à la tolérance de positionnement des métallisations 6 et 7 de part et d'autre de leur position nominale, ce qui fait que les fenêtres 9 et 10 sont toujours entièrement recouvertes respectivement par les métallisations 6 et 7. Si on désigne par B l'écart minimal entre deux métallisations que permet le procédé, la région étroite 5 de la couche isolante 4 qui sépare les fenêtres 9 et 10 a de ce fait une largeur $E_0$ au moins égale à B + 2A.

Par exemple, pour A = 1,75 microns et B = 2,5 microns, il vient $E_0 \geqq$ 6 microns.

Selon les figures 2a à 2d, l'émetteur 3 est réalisé par diffusion à travers une fenêtre 11 séparée d'une fenêtre 12 de contact de base par une région étroite 25 de largeur E inférieure à B + 2A.

La figure 2a montre le dispositif au dernier stade commun avec les procédés antérieurs, à la largeur près de la région étroite 25, à savoir après réalisation de l'émetteur 3 à travers la fenêtre 11.

A la figure 2b, on apporte, par exemple par pulvérisation sur la couche isolante 4 et sur la surface du corps semi-conducteur mise à nu dans les fenêtres 11 et 12, environ 500A de Pt ou de Pt-Ni, de manière à réaliser un alliage pour former une couche de siliciure de Pt désignée par 21 pour l'émetteur 3 et 22 pour la base 2, alors que la couche isolante 4 est recouverte d'une couche de métal non combiné Pt ou Pt-Ni selon le cas. Cette étape est connue en soi et est habituellement utilisée pour réaliser des contacts Schottky. On notera que de manière bien connue, l'effet Schottky est évité lorsque la surface du corps semi-conducteur est très dopée (par exemple $10^{20}$/cm$^2$) soit que la zone semi-conductrice soit elle-même très dopée (par exemple l'émetteur) soit qu'une couche superficielle très dopée ait été réalisée.

L'étape suivante (figure 2c), consiste à décaper sélectivement la couche 24 à l'aide d'une solution connue.

L'étape finale (fig. 2d) consiste à réaliser de manière connue en soi des électrodes conductrices, ici des métallisations d'émetteur 26 et de base 27 d'épaisseur environ 1 micron. Ces métallisations 26 et 27 ont dans l'exemple choisi la même largeur respectivement que les fenêtres de contact 11 et 12 et dans leur position nominale, elles remplissent entièrement celles-ci.

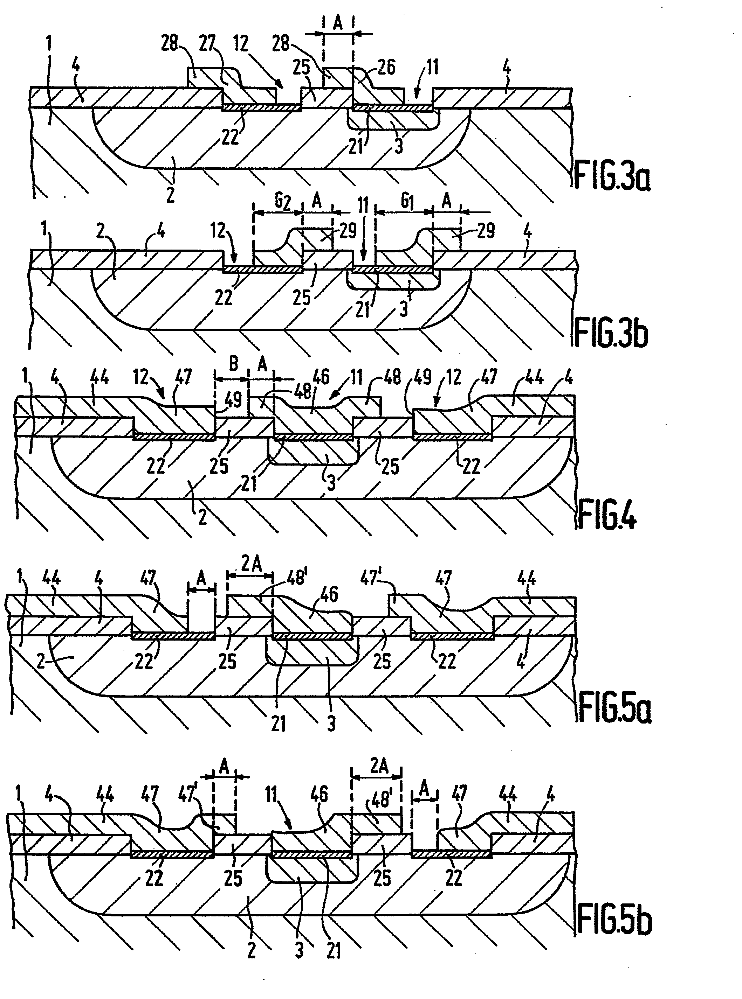

Les figures 3a et 3b illustrent les cas extrêmes de positionnement des métallisations 26 et 27 par rapport aux fenêtres 11 et 12 avec des possibilités de recouvrement de la couche isolante 4 et de la portion étroites 25 en 28 et 29 sur une distance A. On en déduit que tant que la largeur E de la région étroite 25 est supérieure ou égale à A, il ne peut y avoir de court-circuit entre l'émetteur 3 et la base 2 par pontage de la région étroite 25 par l'une ou l'autre des métallisations 26 ou 27.

Par contre si, dans le procédé de fabrication, on a B > A, comme c'est d'ailleurs en général le cas, alors on choisit E = B.

En conclusion, dans ce cas où on accepte que les deux électrodes conductrices adjacentes puissent ne recouvrir que partiellement les fenêtres correspondantes, E peut être choisi au moins égal à la plus grande des deux valeurs A et B, cette valeur étant d'ailleurs en général supérieure à la valeur C. (C est la largeur minimale de la région étroite réalisable lors de la photogravure des fenêtres de contact 11 et 12).

Par exemple, pour A = 1,75 microns B = 2,5 microns, et C = 2 microns, on a E = 2,5 microns au lieu de $E_0$ = 6 microns.

Cette diminution de la largeur E de la région étroite 25 par rapport à la valeur $E_0$ de l'art antérieur permet de diminuer la résistance intrinsèque de base $R_b$. Par contre, si on veut conserver complètement cet avantage au niveau des métallisations 26 et 27, il faut imposer à celles-ci une distance notée G de recouvrement minimum respectivement $G_1$ et $G_2$ de leurs fenêtres correspondantes 11 et 12 de telle sorte que la résistance de contact soit beaucoup plus faible que $R_b$. La largeur des fenêtres 11 et 12 est alors respectivement de $G_1 + A$ et $G_2 + A$, alors que dans l'art antérieur on aurait peut être pu par exemple se contenter des valeurs respectivement $G_1$ et $G_2$. En d'autres termes, l'optimisation de la valeur de la résistance de base $R_b$ ne permet pas obligatoirement de gagner sur les dimensions du transistor : les deux avantages ne sont pas complètement cumulables.

Les figures 4, 5a et 5b, traitent du cas d'un transistor pour hautes fréquences notamment pour hyperfréquences ayant un contact émetteur d'excellente qualité (couche de métal combiné 21 et électrode conductrice, ici la métallisation 46) alors qu'on est moins exigeant pour les contacts de base (couche de métal combiné 22 et électrode conductrice, ici la métallisation 47). Ceci traduit qu'on impose en toutes circonstances un recouvrement total de la fenêtre 11 à travers laquelle a été réalisé l'émetteur par la métallisation 46 alors qu'on tolère un recouvrement seulement partiel des fenêtres 12 de base par la métallisation 47.

Selon la figure 4, les métallisations 46 et 47 sont en position nominale. La métallisation d'émetteur 46 déborde de part et d'autre en 48 d'une quantité A sur deux régions étroites 25 séparant la fenêtre 11 de deux fenêtres 12 recevant chacune une métallisation de base 47. Ces deux métallisations d'émetteur 47 présentent d'un côté un bord 49 jouxtant une des régions étroites 25, et se prolongent du côté opposé en 44 sur la couche isolante 4.

Les figures 5a et 5b représentent les positions nominales extrêmes des métallisations 46 et 47 par rapport aux fenêtres de contact 11 et 12, et montrent que le débordement maximal 48' de la métallisation 46 sur l'une ou l'autre des régions étroites 25 est égal à 2A. Comme les métallisations 46 et 47 sont distantes d'au moins la quantité B (voir fig. 4), on en déduit que la largeur E de la région étroite 25 est dans ce cas au moins égale à la plus grande des deux valeurs $A + B$ et 2A. Pour $B > A$, ce qui est généralement le cas, on aura donc $E = A + B$.

Par exemple, pour $A = 1,75$ microns et $B = 2,5$ microns, on pourra prendre $E = 4,25$ microns.

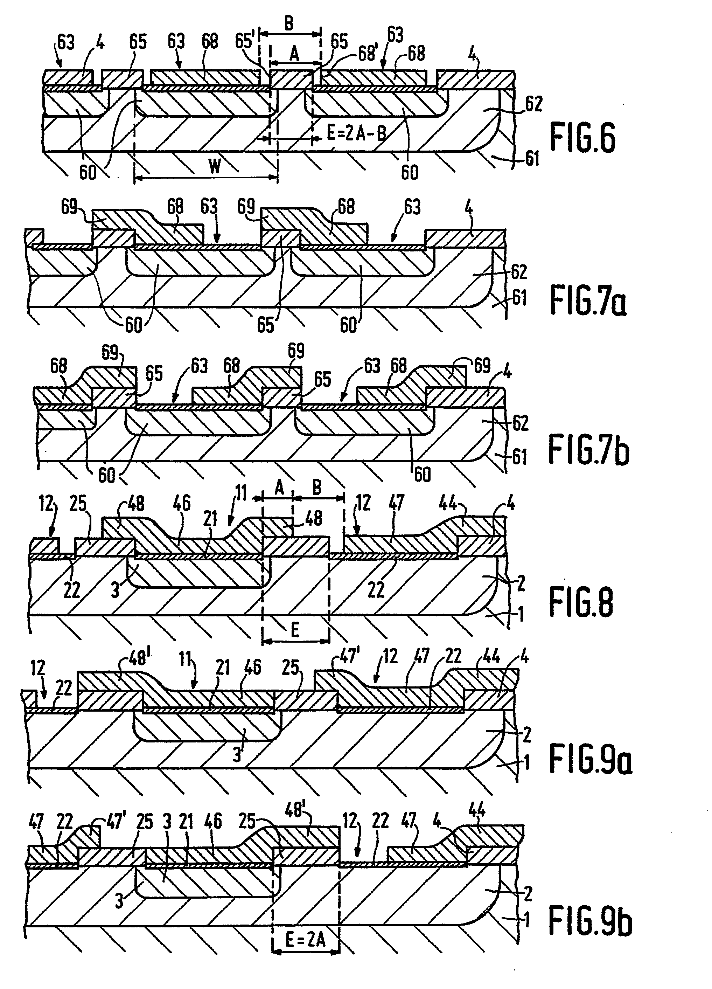

Les figures 6, 7a et 7b traitent du cas d'une structure de transistor logique du type I²L pour un procédé dans lequel $A < B < 2A$. Un tel transistor présente un émetteur 61 constitué par le corps semiconducteur proprement dit, une zone dopée formant une base 62 et des collecteurs 60 de largeur donnée W et qui peuvent être diffusés ou implantés à travers des fenêtres 63 de la couche isolante 4. Les fenêtres 63 sont séparées par des régions étroites 65 de la couche isolante 4.

Pour améliorer le gain des transistors on veut que le rapport entre la largeur du collecteur et celle de la région isolante étroite soit élevé, et étant donné que la valeur de la résistance de contact collecteur n'a pas besoin d'être optimisée, on peut éventuellement donner aux électrodes conductrices, ici les métallisations 68, une largeur inférieure à celle des fenêtres 63, donc en acceptant un recouvrement seulement partiel des fenêtres 63 par les métallisations 68 adjacentes. Comme le montrent les figures 7a et 7b qui illustrent les positions relatives extrêmes des métallisations 68 et des fenêtres 69, le ou les bords 68' des métallisations 68 adjacents à une région étroite 65 doivent être écartés d'au moins la distance A du bord opposé 65' de celle-ci. Cette condition assure en effet que les recouvrements 69 des métallisations 68 sur les régions étroites 65 ne provoquent pas de court-circuit par pontage des régions étroites 65 entre deux collecteurs adjacents.

Pour des métallisations 68 espacées de la quantité B, il vient alors $E \geqq 2A-B$, tout en restant bien entendu au moins égal à C d'où il résulte pour une largeur W donnée des collecteurs 60, une diminution importante des dimensions du transistor accompagnée d'une augmentation notable de son gain.

Par exemple, pour $A = 1,75$ microns et $B = 2,5$ microns on a $E \geqq 1$ micron, soit une valeur très inférieure à $E_0 = $ microns. On doit choisir la valeur minimum C permise par les méthodes de photogravure, par exemple $E = C = 2$ microns.

Les figures 8, 9a et 9b reprennent le cas des figures 5a et 5b, à ceci près que les métallisations 47 de base sont, dans leur position nominale, espacées de la région étroite 25. Comme le montrent les figures 9a et 9b qui illustrent les positions relatives extrêmes des métallisations 46 et 47 par rapport respectivement aux fenêtres 11 et 12, on peut donner à E une valeur au moins égale à 2A, lorsque $A < B$.

Par exemple, pour $A = 1,75$ microns et $B = 2,5$ microns, on a $E = 3,5$ microns, au lieu de $A + B = 4,25$ microns dans le cas de la figure 4 et de $E_0 = 6$ microns dans l'art antérieur.

L'invention ne se limite pas aux modes de réalisation décrits et représentés. Elle s'applique par exemple également aux transistors latéraux de préférence PNP. En outre, en ce qui concerne les transistors I²L elle est aussi bien entendu applicable aux électrodes conductrices du contact de base et de l'injecteur.

L'invention s'applique aussi aux cas où les électrodes conductrices seraient autres que des métallisations.

La description a envisagé à titre d'exemple le cas des transistors. Il va de soi que l'invention s'applique à tous les éléments de circuit présentant des fenêtres de contact adjacentes.

## Revendications

1. Procédé de réalisation d'électrodes conductrices d'un élément de circuit, procédé dans lequel on dépose selon un motif désiré des électrodes conductrices en mettant en œuvre un masque présentant des ouvertures positionnées par rapport à au moins deux fenêtres de contact adjacentes ménagées dans une couche isolante, réalisée sur la surface d'un corps semi-conducteur lesdites fenêtres de contact adjacentes étant disposées au-dessus de deux régions de l'élément de circuit et séparées latéralement par au moins une portion de couche isolante, et présentant une couche de métal se combinant chimiquement avec le matériau de la surface du substrat de telle sorte que les surfaces du substrat mises à nu par les fenêtres soient recouvertes d'une couche de métal combiné, au moins une des deux électrodes adjacentes pouvant ne recouvrir que partiellement la fenêtre de contact correspondante, caractérisé en ce qu'il comporte les étages suivantes :

a) ouvrir dans la couche isolante lesdites fenêtres de contact de telle sorte que ladite portion de couche isolante ait une largeur nominale E supérieure ou égale à C et inférieure à B + 2A, tout en étant suffisante pour que, compte tenu de la position relative des électrodes conductrices et de la portion étroite, et du fait que l'on accepte que, parmi deux électrodes conductrices adjacentes, au moins une d'entre elles puisse ne recouvrir que partiellement la fenêtre de contact correspondante, il n'y ait pas de court-circuit entre deux régions adjacentes par pontage de ladite portion de couche isolante dans les positions extrêmes des électrodes conductrices définies par la tolérance A, avec

A = tolérance de positionnement des électrodes conductrices par rapport aux fenêtres de part et d'autre de leur position nominale, B = écart minimal entre deux électrodes conductrices,

C = largeur minimale de la région de couche isolante permise par les techniques de photogravure,

b) déposer ladite couche de métal.

c) déposer à l'aide dudit masque lesdites électrodes conductrices selon le motif désiré.

2. Procédé selon la revendication 1, caractérisé en ce que lesdites électrodes conductrices ont une largeur au moins égale à celle desdites fenêtres de contact correspondantes, en ce que, dans les conditions nominales, ledit masque est disposé de manière telle qu'au moins un bord de chaque électrode conductrice susceptible de pouvoir ne recouvrir que partiellement la fenêtre de contact correspondante coïncide avec le bord de la fenêtre de contact correspondante jouxtant ladite portion de couche isolante et en ce que la valeur nominale E de cette dernière est au moins égale à la plus grande des deux valeurs : A(3-p); B + (2-p)A;

avec p = nombre entier égal à 1 ou 2, selon qu'il soit toléré que, parmi deux électrodes conductrices adjacentes, une d'entre elles ou les deux puissent ne recouvrir que partiellement les fenêtres correspondantes.

3. Procédé selon la revendication 2, caractérisé en ce que l'élément de circuit est un transistor pour très hautes fréquences, en ce que, pour conserver un contact émetteur de résistance minimale, un recouvrement seulement partiel n'est accepté que pour deux électrodes conductrices de base situées de part et d'autre d'une électrode conductrice d'émetteur (p = 1), la fenêtre de contact d'émetteur présentant donc deux régions de couche isolante qui la bordent latéralement, et sur lesquelles, en position nominale, l'électrode conductrice d'émetteur déborde de part et d'autre de la quantité A et en ce que, en position nominale les électrodes conductrices de base remplissent entièrement la fenêtre de contact de base, ce qui permet de diminuer les dimensions du transistor.

4. Procédé selon la revendication 2 caractérisé en ce que p=2, en ce que l'élément de circuit est un transistor, en ce qu'il comporte une première fenêtre de contact de base et une première fenêtre de contact d'émetteur du transistor et en ce que la largeur E de la portion de couche isolante est égale à B.

5. Procédé selon la revendication 2, caractérisé en ce que p = 2, en ce que l'élément de circuit est un transistor en ce qu'il comporte une deuxième fenêtre de contact de base et une deuxième fenêtre de contact d'émetteur du transistor, en ce que, pour obtenir une résistance de base minimale, on impose que la largeur minimale des portions des électrodes conductrices effectivement en contact avec le corps semi-conducteur soit dans chacune des fenêtres égale à G, et en ce que, la largeur des fenêtres de contact et des électrodes conductrices d'émetteur et de base est égale à A + G.

6. Procédé selon la revendication 1, caractérisé en ce que, pour obtenir des dimensions latérales minimales, chaque électrode conductrice susceptible de ne pouvoir recouvrir que partiellement la fenêtre correspondante a une largeur utile inférieure à celle de la fenêtre correspondante.

7. Procédé selon la revendication 6 et dans lequel A < B < 2A caractérisé en ce que la valeur nominale E de ladite portion de couche isolante est au moins égale à 2A - (p-1)B, avec p = nombre entier égal à 1 ou 2, selon qu'il soit toléré que, parmi deux électrodes conductrices adjacentes, une d'entre elles ou les deux puissent ne recouvrir que partiellement les fenêtres correspondantes.

8. Procédé selon une des revendications 6 ou 7 caractérisé en ce que l'élément de circuit est un transistor du type multi-collecteurs $I^2L$ avec p = 2, et en ce que lesdites fenêtres de contact sont des fenêtres de collecteur.

9. Procédé selon la revendication 8 caractérisé en ce que ladite valeur nominale E est inférieure à B.

10. Procédé selon une des revendications précédentes caractérisé en ce que ledit métal se combinant chimiquement avec le matériau du substrat est choisi parmi le Pt et le Pt-Ni.

**Claims**

1. A method of manufacturing conductive electrodes for a circuit element in which conductive electrodes are provided in accordance with a desired pattern by using a mask, which mask comprises openings positioned with respect to at least two adjacent contact windows in an insulating layer which is present on the surface of a semiconductor body, said adjacent contact windows being located on two regions of the said circuit element and being laterally separated by at least one region of the insulating layer, and which mask comprises a metal layer which combines chemically with the substrate surface material in such a way that the surface areas of the substrate left exposed by the windows are covered by a layer of metal compound, while at least one of the two conductive electrodes can only partly cover the corresponding contact window, characterized in that

a) opening the said contact windows in the insulating layer in such a manner that the said region of the insulating layer has a nominal width E greater than or equal to C and smaller than B + 2A, which is to be sufficient to prevent a short-circuit between two adjacent regions owing to bridging of the said region of the insulating layer in the extreme positions of the metallisations defined by the tolerance A whilst allowing for the relative position of the metallisations and the region of the insulating layer and for the fact that it is tolerated that of said two adjacent conductive electrodes at least one can only partly cover the corresponding contact window, where

A = tolerance of positioning the conductive electrodes with respect to the windows, B = minimum distance between two conductive electrodes,

C = minimum width of the region of the insulating layer realizable by photo-etching techniques,

b) providing the said metal layer,

c) providing the said conductive electrodes in accordance with the desired pattern with the aid of the said mask.

2. A method as claimed in Claim 1, characterized in that the said conductive electrodes have a width which is at least equal to that of the said corresponding contact windows and that, under nominal conditions, the said mask is arranged in such a manner that at least a boundary of each conductive electrode capable of only partly covering the corresponding window coincides with the edge of the corresponding window contiguous to the said region of the insulating layer, and that finally the nominal value E of the narrow region is at least equal to the higher of two values A(3-p); B + (2-p)A, where p = integer equal to 1 or 2 according to whether it is tolerated that of two adjacent metallisations one or both may only partly cover the corresponding contact windows.

3. A method as claimed in Claim 2, characterized in that the circuit element is a transistor for very high frequencies, in that for preserving a minimum emitter contact resistance an only partial covering is only tolerated for two conductive base electrodes situated on either side of a conductive electrode (p=1), the emitter contact window adjoining two insulating layer regions bordering laterally said emitter contact window and on which, in the nominal position, the conductive emitter electrode overlaps said regions on either side by a quantity A, and in that, in the nominal position, the conductive base electrodes entirely fill the base contact windows, which makes it possible to reduce the dimensions of the transistor.

4. A method as claimed in Claim 2, characterized in that p = 2, in that the circuit element is a transistor, in that it comprises a first base contact window and a first emitter contact window of the transistor and in that the width E of the insulating layer portion is equal to B.

5. A method as claimed in Claim 2, characterized in that p = 2, in that the circuit element is a transistor, in that it comprises a second base contact window and a second emitter contact window of the transistor, in that for obtaining a minimum base resistance the minimum width of the portions of the conductive electrodes in effective contact with the semiconductor body should in each of the windows be equal to G, and in that the width of the contact windows and of the conductive emitter and base electrodes is equal to A + G.

6. A method as claimed in Claim 1, characterized in that for obtaining the minimum lateral dimensions each conductive electrode which is capable of only partly covering the corresponding window has a useful width which is less than that of the corresponding window.

7. A method as claimed in Claim 6, in which A < B < 2A, characterized in that the nominal value E of said insulating layer portion is at least equal to 2A - (p-1)B, where p = integer equal to 1 or 2, according to whether it is tolerated that of two adjacent conductive electrodes one of them or both may only partly cover the corresponding window.

8. A method as claimed in Claims 6 or 7, characterized in that the circuit element is a transistor of the multicollector I$^2$L type with p = 2, and in that the said contact windows are collector windows.

9. A method as claimed in Claim 8, characterized in that the said nominal value E is lower than B.

10. A method as claimed in any of the preceding claims, characterized in that the said metal which chemically combines with the material of the substrate is chosen from Pt and Pt-Ni.

**Patentansprüche**

1. Verfahren zur Herstellung von Kontakten für ein Schaltungselement, bei dem unter Verwendung einer Maske Kontakte entsprechend einem gewünschten Muster vorgesehen werden, wobei diese Maske Öffnungen aufweist, die gegenüber wenigstens zwei benachbarten Kontaktfenstern in einer Isolierschicht liegen, die auf der Oberfläche eines Halbleiterkörpers vorhanden ist, wobei diese benachbarten Kontaktfenster auf zwei Gebieten des genannten Schaltungselementes liegen und in seitlicher Richtung durch wenigstens ein Gebiet der Isolierschicht voneinander getrennt sind, und wobei diese Maske eine Metallschicht aufweist, die derart mit dem Werkstoff der Substratoberfläche chemisch vereinigt, daß die durch die Fenster freigelassenen Oberflächengebiete des Substrats durch eine Metallverbindungsschicht bedeckt werden, während wenigstens einer der Kontakte das entsprechende Kontaktfenster nur teilweise bedecken kann, dadurch gekennzeichnet, daß das Verfahren die nachfolgenden Verfahrensschritte aufweist:

a) das Öffnen der genannten Kontaktfenster in der Isolierschicht, und zwar derart, daß das genannte Gebiet der Isolierschicht eine Nennbreite E hat, die größer ist als oder ebenso groß ist wie C und kleiner ist als B + 2A, was ausreicht um einen Kurzschluß zwischen zwei benachbarten Gebieten zu vermeiden, der durch eine Überbrückung des genannten Gebietes der Isolierschicht in den äußersten Stellen der Kontakte, definiert durch die Toleranz A, verursacht werden kann, dies alles unter Berücksichtigung der relativen Lage der Kontakte und des engen Teils und unter Berücksichtigung der Tatsache, daß akzeptiert wird, daß von zwei benachbarten Kontakten mindestens einer derselben das entsprechende Kontaktfenster nur teilweise bedecken kann, wobei

A = Toleranz der Lage der Kontakte gegenüber den Fenstern nach beiden Seiten ihrer Nennlage,

B = minimaler Abstand zwischen zwei Kontakten,

C = minimale Breite des Gebietes der Isolierschicht, die mit einem Photo-Ätzverfahren erzielbar ist,

b) das Anbringen der genannten Metallschicht,

c) das mit Hilfe der genannten Maske entsprechend dem gewünschten Muster Anbringen der genannten Kontakte.

2. Verfahren nach Anspruch 1, dadurch gekennzeichnet, daß die genannten Kontakte eine Breite aufweisen, die der der entsprechenden Kontaktfenster wenigstens entspricht und daß unter Nennbedingungen die genannte Maske derart angebracht wird, daß wenigstens ein Rand jedes Kontaktes, der imstande ist, das entsprechende Kontaktfenster nur teilweise zu bedecken, mit dem Rand des entsprechenden Kontaktfensters neben dem genannten Isolierschichtteil zusammenfällt, und daß der Nennwert E dieses letztgenannten Teils dem höheren der beiden Werte wenigstens entspricht A(3-p); B + (2-p)A, wobei p = eine ganze Zahl gleich 1 oder 2, je nachdem ob es erlaubt ist, daß von zwei benachbarten Kontakten einer derselben oder beide Kontakte die entsprechenden Fenster nur teilweise bedecken.

3. Verfahren nach Anspruch 2, dadurch gekennzeichnet, daß das Schaltungselement ein Transistor für sehr hohe Frequenzen ist, daß zum Erhalten eines minimalen Emitterkontaktwiderstandes eine nur teilweise Bedeckung nur für zwei Basiskontakte erlaubt ist, die auf beiden Seiten eines Emitterkontaktes liegen (p=1), wodurch das Emitterkontaktfenster zwei Isolierschichtgebiete zeigt, die das Fenster seitlich begrenzen und auf denen in der Nennlage der Emitterkontakt das Gebiet A auf beiden Seiten überlappt, und daß in der Nennlage die Basiskontakte das Basiskontaktfenster völlig füllen, wodurch die Abmessungen des Transistors verringert werden können.

4. Verfahren nach Anspruch 2, dadurch gekennzeichnet, daß p = 2 ist, daß das Schaltungselement ein Transistor ist, daß dieser ein erstes Basiskontaktfenster sowie ein erstes Emitterkontaktfenster aufweist, und daß die Breite E des Isolierschichtteils gleich B ist.

5. Verfahren nach Anspruch 2, dadurch gekennzeichnet, daß p = 2 ist, daß das Schaltungselement ein Transistor ist, daß dieser ein zweites Basiskontaktfenster sowie ein zweites Emitterkontaktfenster aufweist, daß zum Erhalten eines minimalen Basiswiderstandes die minimale Breite der Kontaktteile, die wirklich mit dem Halbleiterkörper in Kontakt sind in jedem der Fenster gleich G ist, und daß die Breite der Kontaktfenster und der Emitter- und Basiskontakte gleich A + G ist.

6. Verfahren nach Anspruch 1, dadurch gekennzeichnet, daß zum Erhalten der minimalen Abmessungen jeder Kontakt, der das entsprechende Fenster nur teilweise bedecken kann, eine nützliche Breite hat, die kleiner ist als das entsprechende Fenster.

7. Verfahren nach Anspruch 6, dadurch gekennzeichnet, daß A < B < 2A ist, dadurch gekennzeichnet, daß der Nennwert E des genannten Isolierschichtteils dem Wert 2A − (p-1)B wenigstens entspricht, wobei p = eine ganze Zahl gleich 1 oder 2, je nachdem, ob es erlaubt ist, daß von den beiden Kontakten einer derselben oder beide Kontakte die entsprechenden Fenster nur teilweise bedecken können.

8. Verfahren nach Anspruch 6 oder 7, dadurch gekennzeichnet, daß das Schaltungselement ein Transistor vom Multikollektortyp I²L-Typ ist mit p = 2, und daß die genannten Kontaktfenster Kollektorfenster sind.

9. Verfahren nach Anspruch 8, dadurch gekennzeichnet, daß der genannte Nennwert E niedriger ist als B.

10. Verfahren nach einem der vorstehenden Ansprüche, dadurch gekennzeichnet, daß das genannte Metall, das sich mit dem Material des Substrats vereinigende Metall aus Pt und Pt-Ni gewählt ist.

FIG.1

FIG.2a

FIG.2b

FIG.2c

FIG.2d

FIG.3a

FIG.3b

FIG.4

FIG.5a

FIG.5b

FIG.6

FIG.7a

FIG.7b

FIG.8

FIG.9a

FIG.9b